# EUROPÄISCHE PATENTSCHRIFT

(11) **EP 4 199 355 B1**
(45) Veröffentlichungstag und Bekanntmachung des Hinweises auf die Patenterteilung: **25.09.2024**
(21) Anmeldenummer: 21214298.8
(22) Anmeldetag: 14.12.2021
(51) Int. Cl.: H03K 17/12, H03K 17/687, H03K 17/14

(54) **ELEKTRONISCHE SCHALTUNGSANORDNUNG ZUR STROMVERTEILUNG**
ELECTRONIC CIRCUIT ASSEMBLY FOR CURRENT DISTRIBUTION
AGENCEMENT DU CIRCUIT ÉLECTRONIQUE DESTINÉ À LA DISTRIBUTION DE COURANT

(43) Veröffentlichungstag der Anmeldung: 21.06.2023
(73) Patentinhaber: dSPACE GmbH, 33102 Paderborn (DE)
(72) Erfinder: Gruber, Paul, 33102 Paderborn (DE)

(56) Entgegenhaltungen:
- WO-A2-2005/015741
- JP-A- H09 289 442
- JP-A- S6 198 018
- US-A1- 2013 002 214
- DIVERSE: "Differential Amplifier", WIKIPEDIA, 4 December 2021 (2021-12-04), INTERNET, pages 1 - 10, XP055925476, Retrieved from the Internet <URL:https://en.wikipedia.org/w/index.php?title=Differential_amplifier&oldid=1058519695> [retrieved on 20220527]

## Beschreibung

Die Erfindung betrifft eine elektronische Schaltungsanordnung zur Stromverteilung. Auch betrifft die Erfindung ein Verfahren zur gleichmäßigen Aufteilung eines Stroms sowie die Verwendung der elektronischen Schaltungsanordnung in einer Schaltung zur Simulation einer Batterie.

Es gibt viele Gründe Schaltelemente parallel zu betreiben. Ein Grund für eine Parallelschaltung beispielsweise von Transistoren ist es eine verbesserte Entwärmung zu erreichen. Voraussetzung dafür ist eine gleichmäßige Stromverteilung.

Der in dieser Beschreibung verwendete Begriff "Parallelschaltung" zweier Elemente ist so zu verstehen, dass diese Elemente parallel betrieben werden.

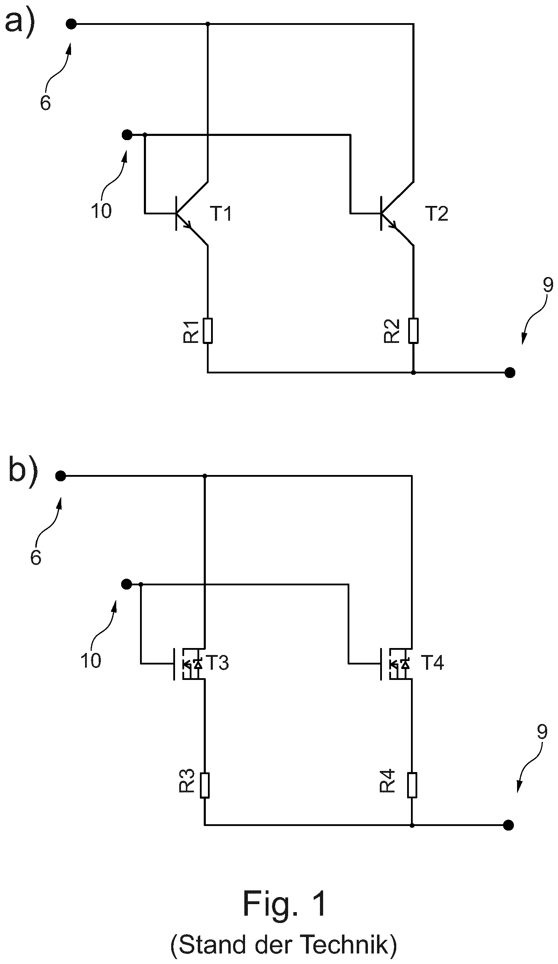

Aus dem Stand der Technik sind beispielsweise die in den Fig. 1 a) und 1 b) gezeigten Grundschaltungen parallelgeschalteter Transistoren T1, T2, T3, T4 bekannt. Diese Schaltungen sind u.a. dazu geeignet, die Verlustleistung einen an einem Eingangsanschluss 6 anliegenden Strom nach einem Ausgangsanschluss 9 auf mehrere parallelgeschaltete Transistoren T1, T2, T3, T4 zu verteilen. Die in den Fig. 1 a) und b) gezeigten elektronischen Schaltungen verfügen jeweils über einen Anschluss 10 für eine Steuerspannung. Eine Parallelschaltung von Transistoren für eine Stromverteilung birgt jedoch immer die Herausforderung, Strom bzw. Verlustleistung möglichst gleichmäßig zu verteilen, damit einzelne Bauteile nicht überhitzen. Dies ist schaltungstechnisch zwar einfach machbar, z.B. indem man in jede Emitter- bzw. Source-Leitung einen Serienwiderstand R1, R2, R3, R4 einfügt. Dieser Serienwiderstand R1, R2, R3, R4 muss jedoch recht groß sein, um ein thermisches Durchgehen über weite Lastbereiche sicher zu verhindern. Hierdurch können sich jedoch Spannungsabfälle ergeben, die eine zusätzliche Verlustleistung schaffen und daher sich störend auf die Stromverteilung auswirken können. Anwendungen mit kleinen Spannungen bei hohen Strömen machen die Stromverteilung schwieriger als z.B. bei Audioendstufen.

Das Dokument JPS6198018A zeigt eine ähnliche Anordnung nach dem Stand der Technik.

Es ist daher die Aufgabe der vorliegenden Erfindung, den Stand der Technik weiterzubilden. Bevorzugt wird eine elektronische Schaltung angegeben, bei der mehrere MOSFETs parallelgeschaltet werden, um im vorwiegend linearen Betrieb der MOSFETs die maximale Verlustleistung bei einer gleichmäßigen Aufteilung des Stroms zu erhöhen. Als ein "linearer Betrieb" oder auch als eine "lineare Betriebsart" eines MOSFETs wird in Fachkreisen, wie auch in dem vorliegenden Kontext, eine Art und Weise einer Nutzung des MOSFETs bezeichnet, bei der der MOSFET durch eine vordefinierte Gate-Source-Spannung nicht voll durchgesteuert ist, oder anders ausgedrückt: Es weist der MOSFET im linearen Betrieb bei einem gegebenen Drain-Source-Strom eine signifikant höhere N-te Drain-Source-Spannung auf, als - insbesondere bei voll durchgesteuertem MOSFET - eine minimale beim gegebenen Drain-Source-Strom erzielbare M-te Drain-Source-Spannung.

Diese Aufgabe wird durch technische Gegenstände nach den unabhängigen Ansprüchen gelöst. Technisch vorteilhafte Ausführungsformen sind Gegenstand der abhängigen Ansprüche, der Beschreibung und der Zeichnungen.

Gemäß einem Aspekt wird die technische Aufgabe der Erfindung durch eine elektronische Schaltungsanordnung zur gleichmäßigen Aufteilung eines Stroms gelöst, mit einem ersten MOSFET und einem zweiten MOSFET, wobei der erste MOSFET und der zweite MOSFET verschaltet sind, um einen an einem Eingangsanschluss anliegenden Strom an einen Ausgangsanschluss der Schaltungsanordnung zu verteilen, wobei der Eingangsanschluss jeweils mit dem Drain-Anschluss des ersten MOSFET und mit dem Drain-Anschluss des zweiten MOSFET verbunden ist, die elektronische Schaltungsanordnung einen Anschluss für eine Steuerspannung umfasst, wobei die Steuerspannung am Gate-Anschluss des ersten MOSFET und am Gate-Anschluss des zweiten MOSFET anliegt, der erste MOSFET am Gate-Anschluss einen ersten Widerstand und der zweite MOSFET am Gate-Anschluss einen zweiten Widerstand umfasst, der Source-Anschluss des ersten MOSFET mit einem ersten Source-Widerstand und der Source-Anschluss des zweiten MOSFET mit einem zweiten Source-Widerstand verbunden sind, wobei der erste Source-Widerstand und der zweite Source-Widerstand mit dem Ausgangsanschluss der Schaltungsanordnung verbunden sind, dadurch gekennzeichnet, dass die Schaltungsanordnung einen ersten Transistor umfasst, wobei die Basis des ersten Transistors mit dem Source-Anschluss des ersten MOSFET verbunden ist, die Schaltungsanordnung einen zweiten Transistor umfasst, wobei die Basis des zweiten Transistors mit dem Source-Anschluss des zweiten MOSFET verbunden ist, der Emitter-Anschluss des ersten Transistors und der Emitter-Anschluss des zweiten Transistors mit einer Stromquelle verbunden sind, der Kollektor-Anschluss des ersten Transistors mit dem Gate-Anschluss des ersten MOSFET und der Kollektor-Anschluss des zweiten Transistors mit dem Gate-Anschluss des zweiten MOSFET verbunden sind, wobei der erste Transistor und der zweite Transistor derart eingerichtet sind, den Strom durch den ersten MOSFET und den Strom durch den zweiten MOSFET auszugleichen, der erste Transistor in Bezug zum ersten MOSFET und der zweite Transistor in Bezug zum zweiten MOSFET derart in der Schaltungsanordnung angeordnet sind, dass zwischen dem ersten MOSFET und dem ersten Transistor eine thermische Kopplung hergestellt ist, ebenso zwischen dem zweiten MOSFET und dem zweiten Transistor, wobei der erste Transistor und der zweite Transistor derart eingerichtet sind, die Gatespannungen der zugehörigen MOSFETs basierend auf der thermischen Kopplung anzupassen.

Grundidee der vorliegenden Erfindung ist es, bei jedem MOSFET ein Transistor derart zu platzieren, dass der Transistor mit dem MOSFET thermisch gekoppelt ist. Hierdurch wird der technische Vorteil erreicht, dass die Transistoren auch als Temperaturfühler dienen und nicht nur der Strom, sondern auch die Temperatur zwischen den parallelgeschalteten MOSFETs ausgeglichen wird. Dabei kann die Schaltung mit sehr kleinen Source-Widerständen arbeiten, was den Spannungsverlust im voll durchgesteuerten Zustand verringert. Hierdurch kann die maximale Verlustleistung bei parallelgeschalteten MOSFETs erhöht werden.

In einer technisch vorteilhaften Ausführungsform der elektronischen Schaltungsanordnung umfasst der erste Transistor am Kollektor-Anschluss einen ersten Kondensator und der zweite Transistor umfasst am Kollektor-Anschluss einen zweiten Kondensator. Dadurch wird der technische Vorteil erreicht, dass das Verhalten bei höheren Frequenzen verbessert wird.

In einer technisch vorteilhaften Ausführungsform der elektronischen Schaltungsanordnung umfasst der erste Transistor am Kollektor-Anschluss eine erste Diode und der zweite Transistor umfasst am Kollektor-Anschluss eine zweite Diode. Hierdurch wird der technische Vorteil erreicht, dass ein Clampen negativer Gatespannungen vermieden wird. Unter dem Fachausdruck des "Clampens" (abgeleitet aus dem engl. Wort "to clamp" für "arretieren" oder "feststellen" oder "einklemmen" etc.) ist in dem vorliegenden Kontext ein Vorgang zu verstehen, der innerhalb der erfindungsgemäßen elektronischen Schaltungsanordnung unter vordefinierten Randbedingungen auftreten kann, und wobei an dem ersten MOSFET und/oder an dem zweiten MOSFET die jeweils anliegende/n Gate-Source-Spannung/en durch den/die MOSFET/MOSFETs umgebende/n Ansteuerungsschaltung/en in einem für die Anwendung gemäß der vorliegenden Offenbarung unbeabsichtigtem Umfang begrenzt wird/werden.

In einer technisch vorteilhaften Ausführungsform der elektronischen Schaltungsanordnung umfasst der erste Transistor am Emitter-Anschluss einen dritten Widerstand und der zweite Transistor umfasst am Emitter-Anschluss einen vierten Widerstand. Hierdurch wird der technische Vorteil erreicht, dass der dritte Widerstand und der vierte Widerstand, die an sich exponentielle Spannungs-Strom-Kennlinie der Basis-Emitter-Strecke von dem ersten Transistor und dem zweiten Transistor etwas linearisiert. Hierdurch kann die Wirksamkeit der Korrektur dosiert werden.

In einer technisch vorteilhaften Ausführungsform der elektronischen Schaltungsanordnung sind der erste Transistor und der zweite Transistor Bipolartransistoren.

In einer technisch vorteilhaften Ausführungsform der elektronischen Schaltungsanordnung sind der erste MOSFET und der erste Transistor mittels eines wärmeleitenden Mediums thermisch miteinander verbunden, ebenso der zweite MOSFET und der zweite Transistor. Mittels eines wärmeleitenden Mediums kann die thermische Kopplung zwischen den Transistoren sichergestellt werden.

In einer technisch vorteilhaften Ausführungsform der elektronischen Schaltungsanordnung ist das wärmeleitende Medium eine Leiterbahn einer gemeinsamen Leiterplatte.

In einer technisch vorteilhaften Ausführungsform der elektronischen Schaltungsanordnung sind mehr als zwei MOSFETs parallelgeschaltet. Die vorliegende Erfindung ist nicht auf zwei parallelgeschaltete MOSFETs begrenzt. Es können eine Mehrzahl von MOSFETs parallelgeschaltet und mittels der erfindungsgemäßen Schaltungsanordnung die maximale Verlustleistung erhöht werden.

In einer technisch vorteilhaften Ausführungsform der elektronischen Schaltungsanordnung umfasst die elektronische Schaltungsanordnung eine zweite elektronische Schaltungsanordnung, wobei die zweite elektronische Schaltungsanordnung einer Spiegelung der ersten elektronischen Schaltungsanordnung entspricht, wobei bei der gespiegelten zweiten elektronischen Schaltungsanordnung die Dotierungen der Transistoren umgekehrt sind, die Durchlassrichtung von Dioden umgekehrt ist, und die Spannungen und Ströme negiert sind, wobei die erste elektronische Schaltungsanordnung und die zweite elektronische Schaltungsanordnung einen gemeinsamen Ausgangsanschluss mit gemeinsamen Source-Widerständen umfasst, oder einen gemeinsamen Ausgangsanschluss mit separaten Source-Widerständen für die erste elektronische Schaltungsanordnung und die zweite elektronische Schaltungsanordnung umfasst.

Gemäß einem weiteren Aspekt wird die technische Aufgabe der Erfindung durch ein Verfahren zur gleichmäßigen Aufteilung eines Stroms gelöst, das Verfahren umfassend die folgenden Schritte:
- Bereitstellen einer elektronische Schaltungsanordnung mit einer im vorherigen Text beschriebenen erfinderischen Merkmalskombination,
- Ausgleichen eines am Eingangsanschluss anliegenden Stroms nach einem Ausgangsanschluss mittels des ersten MOSFETs und des zweiten MOSFETs, wobei die Gatespannung des ersten MOSFET mittels des ersten Transistors und die Gatespannung des zweiten MOSFET mittels des zweiten Transistors angepasst wird, wobei durch eine thermische Kopplung zwischen dem ersten MOSFET und dem ersten Transistor und einer thermischen Kopplung zwischen dem zweiten MOSFET und dem zweiten Transistor, der Strom zusätzlich bei einer Ungleichheit der Temperatur zwischen dem ersten MOSFET und dem zweiten MOSFET ausbalanciert wird.

Auch betrifft die Erfindung die Verwendung der zuvor beschriebenen elektronischen Schaltungsanordnung zur gleichmäßigen Aufteilung eines Stroms und einer temperaturabhängigen Ausbalancierung des Stroms gemäß dem Verfahren in einer Schaltung zur Simulation einer Batterie. Die Erfindung ist hilfreich, wenn mehrere MOSFETs parallelgeschaltet werden, um im linearen Betrieb die maximale Verlustleistung zu erhöhen. Dies kann beispielsweise bei einem Batteriezellen-Simulation-Board eingesetzt werden. Eine simulierte Batteriezelle kann dabei sowohl Energie abgeben wie auch aufnehmen. Im letzteren Fall wird diese Energie im Simulator in Wärme umgesetzt.

Ausführungsbeispiele der Erfindung sind in den Zeichnungen dargestellt und werden im Folgenden näher beschrieben.

Es zeigen:
- Fig. 1: zwei Schaltbilder zweier Transistorschaltungen aus dem Stand der Technik, wobei Fig. a) ein Schaltbild mit zwei parallelgeschalteten bipolaren Transistoren und Fig. 1 b) ein Schaltbild mit zwei parallelgeschalteten MOSFETs zeigt,
- Fig. 2: ein Schaltbild einer elektronischer Schaltungsanordnung zur Aufteilung eines Stroms gemäß einem Ausführungsbeispiel der Erfindung,
- Fig.3: ein Schaltbild einer elektronischer Schaltungsanordnung zum Aufteilen eines Stroms gemäß einem weiteren Ausführungsbeispiel der Erfindung,
- Fig. 4: ein Ablaufdiagramm eines Verfahrens zur gleichmäßigen Aufteilung eines Stroms gemäß einem Ausführungsbeispiel der Erfindung.

Die Figuren 1 a) und 1 b) zeigen zwei Schaltbilder zweier Transistorschaltungen aus dem Stand der Technik und wurden bereits im einleitenden Teil der Beschreibung beschrieben.

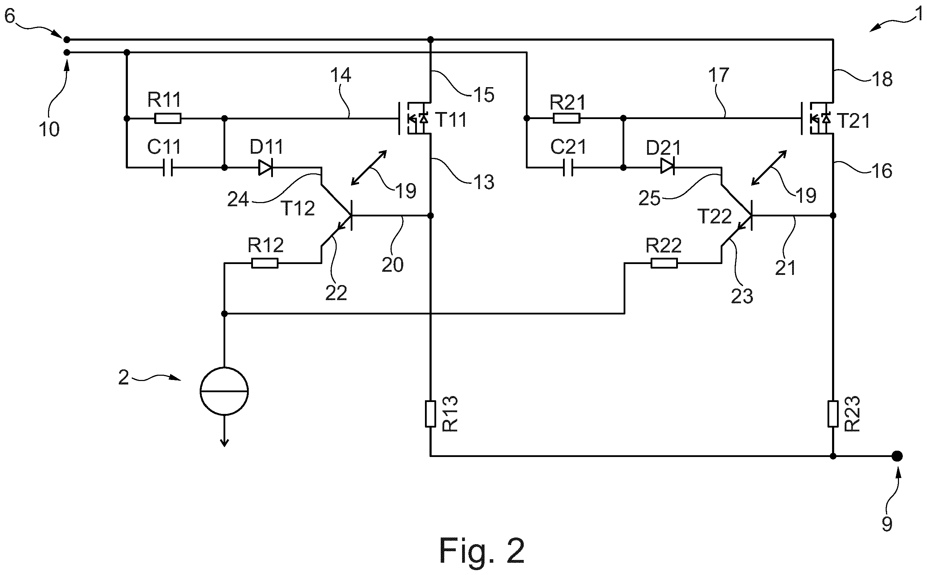

Die Fig. 2 zeigt ein Schaltbild einer elektronischer Schaltungsanordnung 1 zur gleichmäßigen Aufteilung eines Stroms gemäß einem ersten Ausführungsbeispiel der Erfindung. Der Grundgedanke ist, den Strom von einem Eingangsanschluss 6 der Schaltung nach einem Ausgangsanschluss 9 der Schaltung auf die MOSFETs T11 und T21 zu verteilen. Zur Vereinfachung sind in dem in Fig. 2 gezeigten Ausführungsbeispiels nur zwei parallelgeschaltete MOSFETs T11 und T21 gezeigt. Die erfindungsgemäße Idee kann jedoch auf mehr als zwei parallelgeschalteter MOSFETs ausgeweitet werden. Jeder der in Fig. 2 gezeigten MOSFETs T11, T21 hat einen Source-Widerstand R13 bzw. R23, und einen Transistor T12 bzw. T22. Die Transistoren T12, T22 sind dabei derart bezüglich ihrem jeweiligen MOSFET T11, T21 platziert, dass die Transistoren T12, T22 der Temperatur des jeweiligen MOSFETs T 11, T21 möglichst gut folgen können. Dies wird durch eine thermische Kopplung zwischen dem ersten MOSFET T11 und dem ersten Transistor T12 und einer thermischen Kopplung 19, ebenso zwischen dem zweiten MOSFET T21 und dem zweiten Transistor T22 sichergestellt. In einem Ausführungsbeispiel der Erfindung ist für die thermische Kopplung 19 ein wärmeleitendes Medium vorgesehen. Beispielsweise können Leiterbahnen einer gemeinsam genutzten Platine als wärmeleitendes Medium verwendet werden. Der Emitter-Anschluss 22 des ersten Transistors T12 und der Emitter-Anschluss 23 des zweiten Transistors T22 sind mit einer Stromquelle 2 verbunden. Die Stromquelle 2 ist beispielsweise auf 1mA pro MOSFET T11, T21 dimensioniert, so dass über die Widerstände R11, R21 im Mittel knapp 1V abfällt. Die Steuerspannung 10 ist also etwa 1V höher als der Mittelwert der Gatespannungen. Im Idealfall fließt durch die Widerstände R13 und R23 jeweils exakt die Hälfte des Gesamtstroms. Dadurch sind auch identische Strom- und Spannungsverhältnisse an R12/R22, T12/T22, und R11/R21. Ferner haben im Idealfall T11 und T21 sowie T12 und T22 die gleiche Temperatur. Wird die Balance nun gestört, z.B. T11 durch Bauteilstreuung höher belastet, erhöht sich die Basisspannung von T12. Damit erhöht sich auch der Strom durch R12 und R11, während der Strom durch R22 und R21 sinkt. Die Gatespannung sinkt bei T11 und steigt bei T21, und damit wird der Strom durch T11 und T21 ausgeglichen. Dieser Ausgleich wird nicht perfekt sein, sondern eher einem P-Regelverhalten mit einer relativ niedrigen Verstärkung entsprechen. Nun haben ungleiche Ströme durch T11 und T21 auch ungleiche Temperaturen zur Folge, die sich auch auf T12 und T22 übertragen. Die Basis-Emitter-Spannung von T12 bzw. T22 sinkt bei Erwärmung um etwa 2.1 mV/K. Das führt wiederum zu einem Absenken der Gatespannung des zugehörigen MOSFETs T11, T21 und damit zu einer Entlastung. Die Schaltungsanordnung 1 balanciert also nicht nur den Strom zwischen parallelgeschalteten MOSFETs T11, T21, sondern vor allem die Temperatur. Das ist vor allem nützlich, falls ein MOSFET T11, T21 eine schlechtere Anbindung beispielsweise an einen Kühlkörper hat. Anstelle des sonst zu befürchtenden thermischen Durchgehens (fachsprachlich "Thermal Runaway") wird dieser MOSFET durch die elektronische Schaltungsanordnung 1 gezielt entlastet. Beispielsweise können in einem Ausführungsbeispiel fünf parallelgeschaltete MOSFETs T11, T21, ... für insgesamt 20 A Nennstrom vorgesehen sein. Die Widerstände R13 und R23 können beispielsweise mit 15 mΩ dimensioniert sein. Im Idealfall führt jeder MOSFET T11, T21 4 A und auf die Widerstände R13, R23 fallen 60 mV ab. Wird nun einer der Transistor T12, T22 um 10 °C wärmer, reduziert sich seine Basis-Emitter-Spannung um 21 mV, was am MOSFET T11, T21 in erster Näherung eine Entlastung von gut 1A bringt. Die in Fig. 2 am Kollektor-Anschluss 24 des erste Transistors T12 und am Kollektor-Anschluss 25 des zweiten Transistors T22 gezeigten Kondensatoren C11, C21 verbessern das Verhalten bei höheren Frequenzen. Die Dioden D11 und D21 vermeiden das "Clampen" (siehe hierzu obige Begriffserklärung) negativer Gatespannungen. Die Widerstände R12 und R22 linearisieren etwas die an sich exponentielle Spannungs-Strom-Kennlinie der Basis-Emitter-Strecke T12 bzw. T22. Sie erlauben damit auch, die Wirksamkeit der Korrektur zu dosieren.

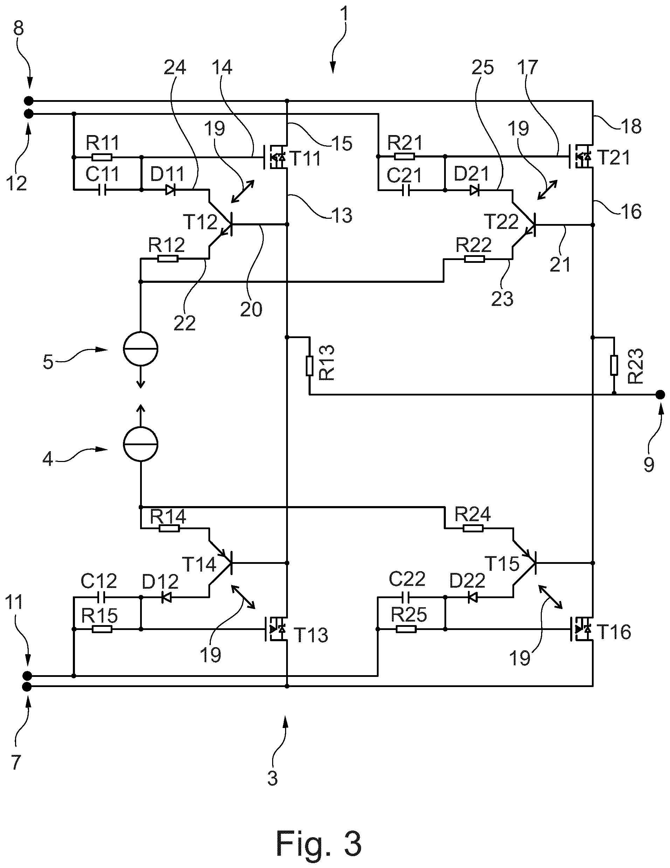

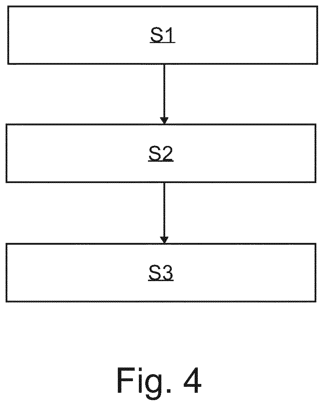

Die Fig. 3 zeigt ein Schaltbild einer elektronischer Schaltungsanordnung 1 zum Aufteilen eines Stroms gemäß einem weiteren Ausführungsbeispiel der Erfindung. Die in Fig. 2 gezeigte elektronische Schaltungsanordnung 1 ist in dem Fig. 3 gezeigten Ausführungsbeispiel gespiegelt dargestellt. Gespiegelt bedeutet in diesem Zusammenhang, dass eine zweite elektronische Schaltungsanordnung 3 vorgesehen ist, wobei NPN-Transistoren gegen PNP-Transistoren sowie N-MOSFETs gegen P-MOSFETs getauscht werden, Dioden umgedreht werden, und Spannungen und Ströme negiert werden. In Fig. 3 ist die Kombination der Schaltungsanordnung aus Fig. 2 und der gespiegelten Schaltung 3 mit je zwei parallelgeschalteten MOSFETs T 11, T21, T13, T16 gezeigt. Die in Fig. 3 gezeigte Schaltungsanordnung 1, 3 umfasst einen Eingangsanschluss 7 sowie einen Steueranschluss 11 für einen negativen Zweig der Schaltungsanordnung 3 und einen Eingangsanschluss 8 sowie einen Steueranschluss 12 für einen positiven Zweig der Schaltungsanordnung 1. Der negative und der positive Zweig nutzen in dem in Fig. 3 gezeigten Ausführungsbeispiel gemeinsame Source-Widerstände R13, R23. In einem Ausführungsbeispiel kann es auch vorgesehen sein, dass die erste elektronische Schaltungsanordnung 1 und die zweite elektronische Schaltungsanordnung 3 einen gemeinsamen Ausgangsanschluss 9 mit separaten Source-Widerständen R13, R23 für die erste elektronische Schaltungsanordnung 1 und die zweite elektronische Schaltungsanordnung 3 aufweist. Der negative und der positive Zweig umfassen jeweils eine Stromquelle 4, 5. Die Stromquellen 4, 5 werden aus Spannungen versorgt, die die Spannung am Ausgangsanschluss 9 hinreichend übersteigen müssen, z.B. gegen den Eingangsanschluss 7, 8. Die Stromquellen 4, 5 müssen ausreichend sein, und den Verstellbereich der Gatespannungen zum Balancieren sicher abzudecken. Dabei bedeutet "hinreichend" oder "ausreichend", dass die Stromquelle (4) von einer so hohen positiven Spannung, und die Stromquelle (5) von einer betragsmäßig so großen negativen Spannung bespeist wird, dass für jede am Ausgang (9) auszugebende Spannung mit allen zu erwartenden Streuungen der Bauteile der Zustand erreichbar ist, in dem alle MOSFETs im M-ten Zustand sind, also die MOSFETs voll durchsteuerbar sind. Fig. 4 zeigt ein Ablaufdiagramm eines Verfahrens zur gleichmäßigen Aufteilung eines Stroms gemäß einem Ausführungsbeispiel der Erfindung. Das Verfahren startet in Schritt S1 mit dem Bereitstellen einer elektronische Schaltungsanordnung 1 wie zuvor beschrieben. In Schritt S2 wird ein am Eingangsanschluss 6 anliegende Strom nach einem Ausgangsanschluss 9 mittels des ersten MOSFETs T11 und des zweiten MOSFETs T21 ausgeglichen. Die Gatespannung 14 des ersten MOSFETs T11 wird dabei mittels des ersten Transistors T12 und die Gatespannung 17 des zweiten MOSFETs T21 mittels des zweiten Transistors T22 angepasst. In Schritt S3 wird aufgrund der thermischen Kopplung 19 zwischen dem ersten MOSFET T11 und dem ersten Transistor T12 und der thermischen Kopplung 19 zwischen dem zweiten MOSFET T21 und dem zweiten Transistor T22, der Strom zusätzlich bei einer Ungleichheit der Temperatur zwischen dem ersten MOSFET T11 und dem zweiten MOSFET T21 ausbalanciert.

Der Schutzbereich der vorliegenden Erfindung ist durch die Patentansprüche gegeben und wird durch die in der Beschreibung erläuterten oder den Figuren gezeigten Merkmale nicht beschränkt.

**Bezugszeichenliste**

| | |
|---|---|
| Elektronische Schaltungsanordnung | 1 |
| Stromquelle | 2 |
| zweite elektronische Schaltungsanordnung | 3 |
| Stromquelle negativer Zweig | 4 |
| Stromquelle positiver Zweig | 5 |
| Eingangsanschluss | 6 |
| Eingangsanschluss negativer Zweig | 7 |
| Eingangsanschluss positiver Zweig | 8 |
| Ausgangsanschluss | 9 |
| Steueranschluss | 10 |
| Steueranschluss negativer Zweig | 11 |
| Steueranschluss positiver Zweig | 12 |
| Source-Anschluss erster MOSFET | 13 |
| Gate-Anschluss erster MOSFET | 14 |
| Drain-Anschluss erster MOSFET | 15 |
| Source-Anschluss zweiter MOSFET | 16 |
| Gate-Anschluss zweiter MOSFET | 17 |
| Drain-Anschluss zweiter MOSFET | 18 |
| thermische Kopplung | 19 |
| Basis erster Transistor | 20 |
| Basis zweiter Transistor | 21 |
| Emitter-Anschluss erster Transistor | 22 |
| Emitter-Anschluss zweiter Transistor | 23 |
| Kollektor-Anschluss erster Transistor | 24 |
| Kollektor-Anschluss zweiter Transistor | 25 |
| Widerstand | R1 |
| Widerstand | R2 |
| bipolarer Transistor | T1 |
| bipolarer Transistor | T2 |
| Widerstand | R3 |
| Widerstand | R4 |
| MOSFET | T3 |
| MOSFET | T4 |
| erster Widerstand | R11 |
| dritter Widerstand | R12 |
| Source-Widerstand | R13 |
| Widerstand | R14 |
| Widerstand | R15 |
| zweiter Widerstand | R21 |
| vierter Widerstand | R22 |
| Source-Widerstand | R23 |
| Widerstand | R24 |
| Widerstand | R25 |
| Diode | D11 |
| Diode | D12 |
| Diode | D21 |
| Diode | D22 |
| Kondensator | C11 |
| Kondensator | C12 |
| Kondensator | C21 |
| Kondensator | C22 |
| erster MOSFET | T11 |
| erster bipolarer Transistor | T12 |
| dritter MOSFET | T13 |
| dritter bipolarer Transistor | T14 |
| vierter bipolarer Transistor | T15 |
| vierter MOSFET | T16 |
| zweiter MOSFET | T21 |
| zweiter bipolarer Transistor | T22 |
| Bereitstellen elektronische Schaltungsanordnung | S1 |
| Ausgleichen eines Stroms | S2 |
| Ausbalancieren einer Temperatur | S3 |

## Patentansprüche

1. Elektronische Schaltungsanordnung (1) zur gleichmäßigen Aufteilung eines Stroms mit
einem ersten MOSFET (T11) und einem zweiten MOSFET (T21), wobei der erste MOSFET (T11) und der zweite MOSFET (T21) verschaltet sind, um einen an einem Eingangsanschluss (6) anliegenden Strom an einen Ausgangsanschluss (9) der Schaltungsanordnung (1) zu verteilen, wobei der Eingangsanschluss (6) jeweils mit dem Drain-Anschluss (15) des ersten MOSFET (T11) und mit dem Drain-Anschluss (18) des zweiten MOSFET (T21) verbunden ist,
die elektronische Schaltungsanordnung (1) einen Anschluss für eine Steuerspannung (10) umfasst, wobei die Steuerspannung am Gate-Anschluss (14) des ersten MOSFET (T11) und am Gate-Anschluss (17) des zweiten MOSFET (T21) anliegt,
der erste MOSFET (T11) am Gate-Anschluss (14) einen ersten Widerstand (R11) und der zweite MOSFET (T21) am Gate-Anschluss (17) einen zweiten Widerstand (R21) umfasst,
der Source-Anschluss (13) des ersten MOSFET (T11) mit einem ersten Source-Widerstand (R13) und der Source-Anschluss (16) des zweiten MOSFET (T21) mit einem zweiten Source-Widerstand (R23) verbunden sind, wobei der erste Source-Widerstand (R13) und der zweite Source-Widerstand (R23) mit dem Ausgangsanschluss (9) der Schaltungsanordnung (1) verbunden sind, wobei
die Schaltungsanordnung (1) einen ersten Transistor (T12) umfasst, und wobei die Basis (20) des ersten Transistors (T12) mit dem Source-Anschluss (13) des ersten MOSFET (T11) verbunden ist, die Schaltungsanordnung einen zweiten Transistor (T22) umfasst,
wobei die Basis (21) des zweiten Transistors (T22) mit dem Source-Anschluss (16) des zweiten MOSFET (T21) verbunden ist,
der Emitter-Anschluss (22) des ersten Transistors (T12) und der Emitter-Anschluss (23) des zweiten Transistors (T22) mit einer Stromquelle (2) verbunden sind,
der Kollektor-Anschluss (24) des ersten Transistors (T12) mit dem Gate-Anschluss (14) des ersten MOSFET (T11) und der Kollektor-Anschluss (25) des zweiten Transistors (T22) mit dem Gate-Anschluss (17) des zweiten MOSFET (T21) verbunden sind,
wobei der erste Transistor (T12) und der zweite Transistor (T22) derart eingerichtet sind, den Strom durch den ersten MOSFET (T11) und den Strom durch den zweiten MOSFET (T21) auszugleichen,
der erste Transistor (T12) in Bezug zum ersten MOSFET (T11) und der zweite Transistor (T22) in Bezug zum zweiten MOSFET (T21) derart in der Schaltungsanordnung angeordnet sind, dass zwischen dem ersten MOSFET (T11) und dem ersten Transistor (T12) eine thermische Kopplung (19) hergestellt ist, ebenso zwischen dem zweiten MOSFET (T21) und dem zweiten Transistor (T22),
wobei der erste Transistor (T12) und der zweite Transistor (T22) derart eingerichtet sind, die Gatespannungen der zugehörigen MOSFETs (T11, T21) basierend auf der thermischen Kopplung (19) anzupassen.

2. Elektronische Schaltungsanordnung (1) nach Anspruch 1, **dadurch gekennzeichnet, dass** der erste Transistor (T12) am Kollektor-Anschluss (24) einen ersten Kondensator (C11) umfasst und der zweite Transistor (T22) am Kollektor-Anschluss (25) einen zweiten Kondensator (C21) umfasst.

3. Elektronische Schaltungsanordnung (1) nach einem der vorherigen Ansprüche, **dadurch gekennzeichnet, dass** der erste Transistor (T12) am Kollektor-Anschluss (24) eine erste Diode (D11) umfasst und der zweite Transistor (T22) am Kollektor-Anschluss (25) eine zweite Diode (D21) umfasst.

4. Elektronische Schaltungsanordnung (1) nach einem der vorherigen Ansprüche, **dadurch gekennzeichnet, dass** der ersten Transistor (T12) am Emitter-Anschluss einen dritten Widerstand (R12) umfasst und der zweite Transistor (T22) am Emitter-Anschluss einen vierten Widerstand (R22) umfasst.

5. Elektronische Schaltungsanordnung (1) nach einem der vorherigen Ansprüche, **dadurch gekennzeichnet, dass** der erste Transistor (T12) und der zweite Transistor (T22) Bipolartransistoren sind.

6. Elektronische Schaltungsanordnung (1) nach einem der vorherigen Ansprüche, **dadurch gekennzeichnet, dass** der erste MOSFET (T11) und der erste Transistor (T12) mittels eines wärmeleitenden Mediums (19) thermisch miteinander verbunden sind, ebenso der zweite MOSFET (T21) und der zweite Transistor (T22).

7. Elektronische Schaltungsanordnung nach Anspruch 6, **dadurch gekennzeichnet, dass** das wärmeleitende Medium eine Leiterbahn einer gemeinsamen Leiterplatte ist.

8. Elektronische Schaltungsanordnung nach einem der vorherigen Ansprüche, **dadurch gekennzeichnet, dass** mehr als zwei MOSFETs (T11, T21) in parallelen Zweigen verschaltet sind.

9. Elektronische Schaltungsanordnung (1) nach einem der vorherigen Ansprüche, **dadurch gekennzeichnet, dass** die elektronische Schaltungsanordnung (1) eine zweite elektronische Schaltungsanordnung (3) umfasst, wobei die zweite elektronische Schaltungsanordnung (3) einer Spiegelung der ersten elektronischen Schaltungsanordnung (1) entspricht, wobei bei der gespiegelten zweiten elektronischen Schaltungsanordnung (3) die Dotierungen der Transistoren (T11, T12,T21, T22, T13, T14, T15, T16) umgekehrt sind, die Durchlassrichtung von Dioden (D11, D21, D12, D22) umgekehrt ist, und die Spannungen und Ströme negiert sind, wobei die erste elektronische Schaltungsanordnung (1) und die zweite elektronische Schaltungsanordnung (3) einen gemeinsamen Ausgangsanschluss (9) mit gemeinsamen Source-Widerständen (R13, R23) umfasst, oder einen gemeinsamen Ausgangsanschluss (9) mit separaten Source-Widerständen (R13, R23) für die erste elektronische Schaltungsanordnung (1) und die zweite elektronische Schaltungsanordnung (3) umfasst.

10. Verfahren zur gleichmäßigen Aufteilung eines Stroms, das Verfahren umfassend die folgenden Schritte:
- Bereitstellen einer elektronischen Schaltungsanordnung (1, 3) nach einem der vorherigen Ansprüche,
- Ausgleichen eines am Eingangsanschluss (6) anliegenden Stroms nach einem Ausgangsanschluss (9) mittels des ersten MOSFETs (T11) und des zweiten MOSFETs (T21), wobei die Gatespannung (14) des ersten MOSFETs (T11) mittels des ersten Transistors (T12) und die Gatespannung (17) des zweiten MOSFETs (T21) mittels des zweiten Transistors (T22) angepasst wird,
wobei durch eine thermische Kopplung (19) zwischen dem ersten MOSFET (T11) und dem ersten Transistor (T12) und einer thermischen Kopplung (19) zwischen dem zweiten MOSFET (T21) und dem zweiten Transistor (T22), der Strom zusätzlich bei einer Ungleichheit der Temperatur zwischen dem ersten MOSFET (T11) und dem zweiten MOSFET (T21) ausbalanciert wird.

11. Verwendung der elektronischen Schaltungsanordnung (1) nach einem der vorherigen Ansprüchen 1 bis 9 zur gleichmäßigen Aufteilung eines Stroms und einer temperaturabhängigen Ausbalancierung des Stroms gemäß dem Verfahren nach Anspruch 10 in einer Schaltung zur Simulation einer Batterie.

## Claims

1. An electronic circuit arrangement (1) for uniformly dividing a current, having
a first MOSFET (T11) and a second MOSFET (T21), the first MOSFET (T11) and the second MOSFET (T21) being connected in order to distribute a current applied to an input terminal (6) to an output terminal (9) of the circuit arrangement (1), the input terminal (6) being connected in each case to the drain terminal (15) of the first MOSFET (T11) and to the drain terminal (18) of the second MOSFET (T21),
the electronic circuit arrangement (1) comprising a terminal for a control voltage (10), the control voltage being applied to the gate terminal (14) of the first MOSFET (T11) and to the gate terminal (17) of the second MOSFET (T21),
the first MOSFET (T11) comprising a first resistor (R11) at the gate terminal (14) and the second MOSFET (T21) comprising a second resistor (R21) at the gate terminal (17),
the source terminal (13) of the first MOSFET (T11) being connected to a first source resistor (R13) and the source terminal (16) of the second MOSFET (T21) being connected to a second source resistor (R23), the first source resistor (R13) and the second source resistor (R23) being connected to the output terminal (9) of the circuit arrangement (1), wherein
the circuit arrangement (1) comprises a first transistor (T12), and wherein the base (20) of the first transistor (T12) is connected to the source terminal (13) of the first MOSFET (T11), the circuit arrangement comprises a second transistor (T22),
wherein the base (21) of the second transistor (T22) is connected to the source terminal (16) of the second MOSFET (T21),
the emitter terminal (22) of the first transistor (T12) and the emitter terminal (23) of the second transistor (T22) are connected to a current source (2),
the collector terminal (24) of the first transistor (T12) is connected to the gate terminal (14) of the first MOSFET (T11) and the collector terminal (25) of the second transistor (T22) is connected to the gate terminal (17) of the second MOSFET (T21),
wherein the first transistor (T12) and the second transistor (T22) are configured to equalize the current through the first MOSFET (T11) and the current through the second MOSFET (T21),
the first transistor (T12) is disposed in relation to the first MOSFET (T11) and the second transistor (T22) is disposed in relation to the second MOSFET (T21) in the circuit arrangement such that a thermal coupling (19) is established between the first MOSFET (T11) and the first transistor (T12), and also between the second MOSFET (T21) and the second transistor (T22),
wherein the first transistor (T12) and the second transistor (T22) are configured to adjust the gate voltages of the associated MOSFETs (T11, T21) based on the thermal coupling (19).

2. The electronic circuit arrangement (1) according to claim 1, **characterized in that** the first transistor (T12) comprises a first capacitor (C11) at the collector terminal (24) and the second transistor (T22) comprises a second capacitor (C21) at the collector terminal (25).

3. The electronic circuit arrangement (1) according to any one of the preceding claims, **characterized in that** the first transistor (T12) comprises a first diode (D11) at the collector terminal (24) and the second transistor (T22) comprises a second diode (D21) at the collector terminal (25).

4. The electronic circuit arrangement (1) according to any one of the preceding claims, **characterized in that** the first transistor (T12) comprises a third resistor (R12) at the emitter terminal and the second transistor (T22) comprises a fourth resistor (R22) at the emitter terminal.

5. The electronic circuit arrangement (1) according to any one of the preceding claims, **characterized in that** the first transistor (T12) and the second transistor (T22) are bipolar transistors.

6. The electronic circuit arrangement (1) according to any one of the preceding claims, **characterized in that** the first MOSFET (T11) and the first transistor (T12) are thermally connected to one another by means of a thermally conductive medium (19), as are the second MOSFET (T21) and the second transistor (T22).

7. The electronic circuit arrangement according to claim 6, **characterized in that** the thermally conductive medium is a conductor track of a common printed circuit board.

8. The electronic circuit arrangement according to any one of the preceding claims, **characterized in that** more than two MOSFETs (T11, T21) are connected in parallel.

9. The electronic circuit arrangement (1) according to any one of the preceding claims, **characterized in that** the electronic circuit arrangement (1) comprises a second electronic circuit arrangement (3), wherein the second electronic circuit arrangement (3) corresponds to a mirror image of the first electronic circuit arrangement (1), wherein in the mirrored second electronic circuit arrangement (3) the dopings of the transistors (T11, T12, T21, T22, T13, T14, T15, T16) are reversed, the forward bias of diodes (D11, D21, D12, D22) is reversed, and the voltages and currents are negated, wherein the first electronic circuit arrangement (1) and the second electronic circuit arrangement (3) comprise a common output terminal (9) having common source resistors (R13, R23), or comprise a common output terminal (9) having separate source resistors (R13, R23) for the first electronic circuit arrangement (1) and the second electronic circuit arrangement (3).

10. A method for uniformly dividing a current, the method comprising the following steps:
- providing an electronic circuit arrangement (1, 3) according to any one of the preceding claims,
- equalizing a current applied to the input terminal (6) to an output terminal (9) by means of the first MOSFET (T11) and the second MOSFET (T21), wherein the gate voltage (14) of the first MOSFET (T11) is adjusted by means of the first transistor (T12) and the gate voltage (17) of the second MOSFET (T21) is adjusted by means of the second transistor (T22),
wherein a thermal coupling (19) between the first MOSFET (T11) and the first transistor (T12) and a thermal coupling (19) between the second MOSFET (T21) and the second transistor (T22) additionally balances the current in the event of a temperature imbalance between the first MOSFET (T11) and the second MOSFET (T21).

11. A use of the electronic circuit arrangement (1) according to any one of the preceding claims 1 to 9 for uniformly dividing a current and a temperature-dependent balancing of the current according to the method according to claim 10 in a circuit for simulating a battery.

## Revendications

1. Agencement de circuit électronique (1) pour la répartition uniforme d'un courant, comportant
un premier MOSFET (T11) et un deuxième MOSFET (T21), le premier MOSFET (T11) et le deuxième MOSFET (T21) étant branchés pour distribuer un courant présent sur une borne d'entrée (6) à une borne de sortie (9) de l'agencement de circuit (1), la borne d'entrée (6) étant respectivement connectée à la borne de drain (15) du premier MOSFET (T11) et à la borne de drain (18) du deuxième MOSFET (T21),
l'agencement de circuit électronique (1) comprend une borne pour une tension de commande (10), la tension de commande étant appliquée à la borne de grille (14) du premier MOSFET (T11) et à la borne de grille (17) du deuxième MOSFET (T21),
le premier MOSFET (T11) comprend une première résistance (R11) sur la borne de grille (14) et le deuxième MOSFET (T21) comprend une deuxième résistance (R21) sur la borne de grille (17),
la borne de source (13) du premier MOSFET (T11) est connectée à une première résistance de source (R13) et la borne de source (16) du deuxième MOSFET (T21) est connectée à une deuxième résistance de source (R23), la première résistance de source (R13) et la deuxième résistance de source (R23) étant connectées à la borne de sortie (9) de l'agencement de circuit (1),
l'agencement de circuit (1) comprenant un premier transistor (T12), et la base (20) du premier transistor (T12) étant connectée à la borne de source (13) du premier MOSFET (T11), l'agencement de circuit comprenant un deuxième transistor (T22),
la base (21) du deuxième transistor (T22) étant connectée à la borne de source (16) du deuxième MOSFET (T21),
la borne d'émetteur (22) du premier transistor (T12) et la borne d'émetteur (23) du deuxième transistor (T22) sont connectées à une source de courant (2),
la borne de collecteur (24) du premier transistor (T12) est connectée à la borne de grille (14) du premier MOSFET (T11) et la borne de collecteur (25) du deuxième transistor (T22) est connectée à la borne de grille (17) du deuxième MOSFET (T21),
le premier transistor (T12) et le deuxième transistor (T22) étant conçus pour équilibrer le courant à travers le premier MOSFET (T11) et le courant à travers le deuxième MOSFET (T21),
le premier transistor (T12) est disposé dans l'agencement de circuit par rapport au premier MOSFET (T11) et le deuxième transistor (T22) est disposé dans l'agencement de circuit par rapport au deuxième MOSFET (T21) de telle sorte qu'un couplage thermique (19) est établi entre le premier MOSFET (T11) et le premier transistor (T12), de même qu'entre le deuxième MOSFET (T21) et le deuxième transistor (T22),
le premier transistor (T12) et le deuxième transistor (T22) étant conçus de manière à adapter les tensions de grille des MOSFET (T11, T21) associés sur la base du couplage thermique (19).

2. Agencement de circuit électronique (1) selon la revendication 1, **caractérisé en ce que** le premier transistor (T12) comprend un premier condensateur (C11) à la borne de collecteur (24) et le deuxième transistor (T22) comprend un deuxième condensateur (C21) à la borne de collecteur (25).

3. Agencement de circuit électronique (1) selon l'une des revendications précédentes, **caractérisé en ce que** le premier transistor (T12) comprend une première diode (D11) à la borne de collecteur (24) et le deuxième transistor (T22) comprend une deuxième diode (D21) à la borne de collecteur (25) .

4. Agencement de circuit électronique (1) selon l'une des revendications précédentes, **caractérisé en ce que** le premier transistor (T12) comprend une troisième résistance (R12) à la borne d'émetteur et le deuxième transistor (T22) comprend une quatrième résistance (R22) à la borne d'émetteur.

5. Agencement de circuit électronique (1) selon l'une des revendications précédentes, **caractérisé en ce que** le premier transistor (T12) et le deuxième transistor (T22) sont des transistors bipolaires.

6. Agencement de circuit électronique (1) selon l'une des revendications précédentes, **caractérisé en ce que** le premier MOSFET (T11) et le premier transistor (T12) sont connectés thermiquement l'un à l'autre au moyen d'un milieu thermoconducteur (19), de même que le deuxième MOSFET (T21) et le deuxième transistor (T22).

7. Agencement de circuit électronique selon la revendication 6, **caractérisé en ce que** le milieu thermoconducteur est une piste conductrice d'une carte imprimée commune.

8. Agencement de circuit électronique selon l'une des revendications précédentes, **caractérisé en ce que** plus de deux MOSFET (T11, T21) sont branchés dans des branches parallèles.

9. Agencement de circuit électronique (1) selon l'une des revendications précédentes, **caractérisé en ce que** l'agencement de circuit électronique (1) comprend un deuxième agencement de circuit électronique (3), le deuxième agencement de circuit électronique (3) correspondant à une symétrie du premier agencement de circuit électronique (1), dans le deuxième agencement de circuit électronique (3) en symétrie, les dopages des transistors (T11, T12, T21, T22, T13, T14, T15, T16) étant inversés, le sens passant des diodes (D11, D21, D12, D22) étant inversé, et les tensions et les courants étant logiquement inversés, le premier agencement de circuit électronique (1) et le deuxième agencement de circuit électronique (3) comprenant une borne de sortie (9) commune avec des résistances de source (R13, R23) communes, ou une borne de sortie (9) commune avec des résistances de source (R13, R23) séparées pour le premier agencement de circuit électronique (1) et le deuxième agencement de circuit électronique (3).

10. Procédé pour la répartition uniforme d'un courant, le procédé comprenant les étapes suivantes :
- fourniture d'un agencement de circuit électronique (1, 3) selon l'une des revendications précédentes,
- équilibrage d'un courant appliqué à la borne d'entrée (6) vers une borne de sortie (9) au moyen du premier MOSFET (T11) et du deuxième MOSFET (T21), la tension de grille (14) du premier MOSFET (T11) étant adaptée au moyen du premier transistor (T12) et la tension de grille (17) du deuxième MOSFET (T21) au moyen du deuxième transistor (T22),
le courant étant en plus équilibré en cas d'inégalité de température entre le premier MOSFET (T11) et le deuxième MOSFET (T21) par un couplage thermique (19) entre le premier MOSFET (T11) et le premier transistor (T12) et entre le deuxième MOSFET (T21) et le deuxième transistor (T22).

11. Utilisation de l'agencement de circuit électronique (1) selon l'une des revendications 1 à 9 précédentes pour répartir uniformément un courant et équilibrer le courant en fonction de la température conformément au procédé selon la revendication 10 dans un circuit de simulation d'une batterie.
